Europäisches Patentamt

European Patent Office

Office européen des brevets

(19)

(11) Publication number: **0 281 233**
**A1**

# (12) EUROPEAN PATENT APPLICATION

(21) Application number: 88300543.1

(22) Date of filing: 22.01.88

(51) Int. Cl.⁴: **H01L 21/31**

(30) Priority: 30.01.87 US 8802

(43) Date of publication of application:
07.09.88 Bulletin 88/36

(84) Designated Contracting States:
DE FR GB NL

(71) Applicant: AMERICAN TELEPHONE AND
TELEGRAPH COMPANY
550 Madison Avenue
New York, NY 10022(US)

(72) Inventor: Harrus, Alain Simon
205 east Meade Street
Philadelphia, PA 19118(US)

(74) Representative: Watts, Christopher Malcolm
Kelway et al
AT&T (UK) LTD. AT&T Intellectual Property
Division 5 Mornington Road
Woodford Green Essex IG8 OTU(GB)

(54) **Improved formation of dielectric on deposited silicon.**

(57) A deposited doped silicon layer has formed thereon a dielectric layer of improved quality by depositing an initial undoped portion (11) of the silicon layer, followed by depositing a doped portion (21). The dielectric (31) is then formed, typically by oxidizing the surface of the silicon. The silicon is typically amorphous as deposited, and the dopant is typically phosphorus. The resulting layers may be used in capacitors and other solid state device structures. It appears that the improved dielectric quality, including a higher breakdown voltage and reduced leakage, is due to improved surface smoothness.

FIG. 3

## Improved Formation of a Dielectric on Deposited Silicon

### Background of the Invention

#### 1. Field of the Invention

The present invention relates to an improved method of forming a dielectric layer on a layer of deposited conductive silicon.

#### 2. Description of the Prior Art

In the manufacture of integrated circuits and other solid state devices, it is frequently necessary to oxidize a surface layer of deposited silicon. For example, in forming capacitors in linear integrated circuits, a layer of polysilicon doped with a conductivity enhancing dopant is deposited on a substrate, forming the first plate of a capacitor. The top surface of the polysilicon layer is then oxidized to form a silicon dioxide dielectric, and another layer of doped polysilicon is deposited on the silicon dioxide to form the second plate of the capacitor. In another application, it is known to form an information storage capacitor so as to overlie the substrate of a dynamic random access memory integrated circuit. In still another application, a thin dielectric is formed on the surface of deposited polysilicon to form a "floating gate" in electrically erasable programmable read-only-memories (EEPROMs). It is also known to use oxidized polysilicon as the gate dielectric of an insulated gate field effect transistor, with still other applications being possible. In these and other applications, it is desirable to obtain as good a quality dielectric as possible, which usually means as high a breakdown voltage per unit dielectric thickness as possible.

### Summary of the Invention

I have invented an improved technique for forming a deposited conductive silicon layer having a dielectric layer thereon. An initial portion of the silicon layer is deposited without a dopant followed by depositing of a subsequent portion of the silicon layer with a dopant. A dielectric is then formed on the surface of the silicon. The dopant is typically phosphorous, and the dielectric layer is typically silicon dioxide.

### Brief Description of the Drawing

FIG. 1 shows the deposition of the undoped portion of the silicon layer.
FIG. 2 shows the deposition of the doped portion of the silicon layer.
FIG. 3 shows the dielectric layer as formed on the silicon layer.

### Detailed Description

The following detailed description relates to an improved technique for forming a deposited conductive silicon layer having a dielectric layer on its surface. This technique results from my discovery that a dielectric of improved quality may be formed on the surface of a layer of deposited, doped silicon when an initial portion of the deposited silicon is undoped. I postulate that the improvement in dielectric quality is due an improvement in the surface smoothness of the deposited silicon, as discussed further below.

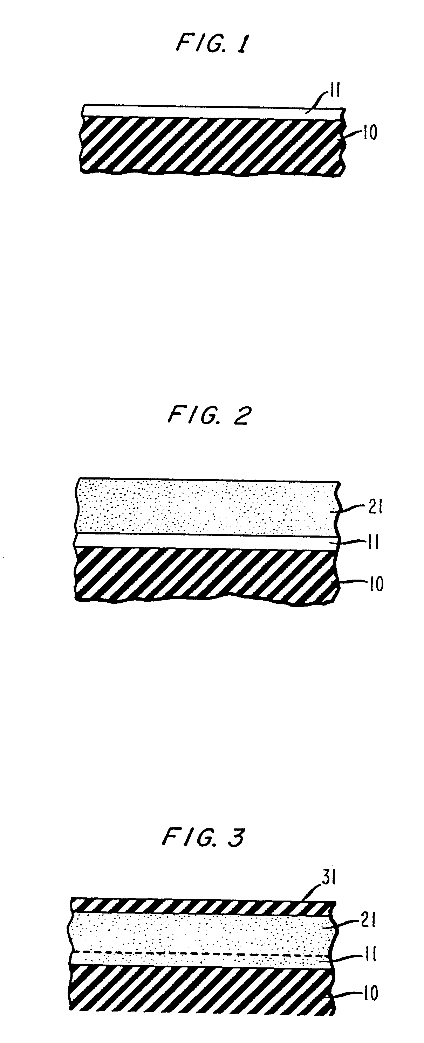

Referring to FIG. 1, in the present technique a portion 11 of undopted silicon is deposited onto a surface of region 10. The region 10 may be, for example, a semiconductor substrate, or a layer of material previously formed thereon. In a typical case, the region 10 is a dielectric layer (e.g., silicon dioxide) overlying a silicon substrate. The silicon portion 11 as deposited is desirably amorphous, although it may alternately be polysilicon having relatively small crystalline grain size as deposited. The deposition may be by any technique, with low pressure chemical vapor deposition (LPCVD) being one suitable technique. The thickness of the undoped silicon layer is typically in the range of 5 to 50 nanometers (50 to 500 angstroms), and preferably in the range of 10 to 30 nanometers (100 to 300 angstroms).

Referring to FIG. 2, following the deposition of the undoped silicon portion, a doped portion 21 is deposited, typically by the same technique as that used for depositing portion 11. However, a dopant is included during the deposition of portion 21. This may conveniently be accomplished with the LPCVD technique by flowing a carrier gas that includes the desired dopant into the reaction chamber where the deposition is accomplished. The thickness of the doped silicon layer may be any desired value, and is typically greater than the thickness of the undoped layer. Phosphorus is the dopant most frequently used to doped deposited silicon, and typically comprises from about 1 to 3 weight percent, and preferably about 1.9 to 2.3 weight percent, of the deposited silicon.

Referring to FIG. 3, a dielectric layer 31 is formed on the exposed (i.e., top) surface of the deposited silicon. The dielectric typically has a thickness in the range of from 5 to 100 nanometers (50 to 1000 angstroms), and most typically in the range of from 10 to 50 nanometers (100 to 500 angstroms). It is typically formed by converting a surface layer of the silicon into a dielectric by heating a reactive ambient. For example, to form silicon dioxide on the surface, the silicon layer is heated in an atmosphere comprising oxygen, which may be either a dry or steam atmosphere. It is also known to use a plasma atmosphere comprising oxygen to oxidize silicon, in which case the temperature required for oxidation is reduced. A nitrogen atmosphere may similarly be used to form a nitride. Furthermore, a deposition process may alternately be used to form the dielectric layer. The elevated temperature of the dielectric formation process is typically sufficient to cause the dopant to diffuse form the upper (doped) portion of the silicon layer to the lower (undoped) portion, as shown in FIG. 3. This diffusion typically produces substantially uniform doping, and hence conductivity, throughout the silicon layer. When the silicon is amorphous as deposited, the heating used in forming the dielectric is also typically sufficient to convert the amorphous silicon into polysilicon. This allows the dopant to increase the conductivity of the silicon, making it useful for a capacitor plate, for example.

The details of one process suitable for implementing the present technique are more fully illustrated by means of the following Example:

EXAMPLE

A layer of undoped silicon approximately 20 nanometers (200 angstroms) thick was deposited on silicon dioxide. The deposition was accomplished by flowing silane ($SiH_4$) at a pressure of 1 torr into a deposition furnace. The deposition temperature of 570 degrees C was sufficiently low to result in amorphous silicon being deposited. A layer of doped silicon 790 nanometers (7900 angstroms) thick was deposited on top of the first layer by continuing the flow of the silane while introducing $PH_3$ into the furnace, thereby co-depositing phosphorus with silicon. The gas ratio of $PH_3$ to $SiH_4$ was 0.0072, producing silicon that included 2 weight percent phosphorus. The surface of the silicon was oxidized by heating at 950 degrees C in oxygen for 10 minutes, which produced a 50 nanometer (500 angstrom) layer of silicon dioxide. This heating was sufficient to diffuse the phosphorus into the undoped portion of the deposited silicon.

More significantly, the heating crystallized the amorphous silicon into polysilicon, allowing the phosphorus to be incorporated into the silicon grains, thereby increasing the conductivity of the deposited silicon. The total thickness of the silicon layer was also reduced from 810 nanometers (8100 angstroms) as deposited in the amorphous state to 650 nanometers (6500 angstroms) in the polycrystalline state after the heating.

To determine the quality of the silicon dioxide layer thus formed, a layer of doped polysilicon was then deposited on the silicon dioxide layer, thereby forming the second plate of a capacitor, with the silicon dioxide layer as the dielectric and the underlying silicon layer as the first plate. The average breakdown voltage of the dielectric for several samples was determined to be approximately 9 megavolts per centimeter. As a control, a capacitor was similarly prepared, except that the silicon did not include the undoped initial portion. Rather, the phosphorous dopant was included throughout the silicon deposition process. The average breakdown voltage of the dielectric for several samples thus prepared was determined to be approximately 6 megavolts per centimeter. In a second comparison, a deposited amorphous silicon layer was doped with phosphorus by reacting the surface of the silicon with $PBr_3$, forming a glass dopant source. A heating step then diffused phosphorus into the underlying silicon, and the glass layer was removed. A silicon dioxide dielectric layer was then formed by heating in an oxygen atmosphere as above. It was found that the leakage current through the dielectric was significantly greater than for a dielectric formed on silicon deposited by the inventive technique. Furthermore, the breakdown field for the samples doped from the glass source was only about 6 megavolts per centimeter.

It appears that the above-noted improvements in the dielectric quality using the inventive technique are due to an improvement in the smoothness of the surface of the deposited silicon prior to forming the dielectric layer. I postulate that when a dopant (e.g., phosphorus) is included in amorphous silicon that is deposited on a surface, the dopant promotes the nucleation of crystalline silicon regions. These crystalline regions apparently form asperities on the surface of the deposited silicon, thus causing a rough surface. When a dielectric is formed (e.g., silicon dioxide grown), the asperities cause the dielectric thickness to vary. Hence, for a given average thickness, the dielectric thickness in some regions will be less. Furthermore, the asperities cause the electric field gradient to be greater in some portions of the dielectric. Hence, the breakdown voltage tends to be less, and the leakage current greater, that for a dielectric formed on silicon deposited according to the present technique. That is, depositing the undoped portion of the silicon layer suppresses the nucleation of the crystalline regions. Therefore, the present technique affords benefits with any dopant that tends to promote nucleation of silicon deposited on a surface. Note that although the dielectric in the above example was grown (i.e., incorporates silicon from the deposited silicon layer), a deposited dielectric also benefits from the improved surface of silicon deposited by the present technique. Furthermore, following the formation of a given dielectric material, an additional dielectric material may be formed. For example, silicon nitride may be grown or deposited on silicon dioxide to form a dual dielectric layer for a capacitor, with still other material combinations being possible. Note finally that although the deposited silicon is desirably amorphous, the use of deposited polysilicon having a relatively small grain size (e.g., less than 1 nanometer in diameter) also benefits from the initial deposition of undoped silicon according to the present technique.

## Claims

1. A method of making a solid state device CHARACTERIZED by step comprising
depositing a first layer (11) of silicon that does not include a conductivity-enhancing dopant onto a surface;
depositing a second layer (21) of silicon that includes a conductivity-enhancing dopant onto said first layer;
and thereafter forming a dielectric layer (31) on the exposed surface of said second layer of silicon.

2. The method of claim 1 wherein said dopant is phosphorus.

3. The method of claim 1 wherein said dielectric layer is silicon dioxide.

4. The method of claim 3 wherein said silicon dioxide is formed by oxidizing the exposed surface of said second layer of silicon.

5. The method of claim 4 wherein said oxidizing is accomplished by heating said silicon in an atmosphere comprising oxygen.

6. The method of claim 5 wherein said heating is accomplished for a time and at a temperature sufficient to diffuse said given dopant from said second layer into said first layer.

7. The method of claim 5 wherein said atmosphere is a dry atmosphere.

8. The method of claim 5 wherein said atmosphere is a steam atmosphere.

9. The method of claim 5 wherein said atmosphere is a plasma atmosphere.

10. The method of claim 1 wherein said silicon is amorphous as deposited.

11. The method of claim 10 wherein said forming a dielectric layer causes the amorphous silicon to convert to polycrystalline silicon.

12. The method of claim 1 wherein said surface onto which said first layer of silicon is deposited is the surface of a dielectric.

13. The method of claim 12 wherein the dielectric onto which said first layer of silicon is deposited is silicon dioxide.

14. The method of claim 1 further comprising the step of depositing a conductor onto said dielectric layer.

15. The method of claim 1 wherein said dielectric layer comprises at least two dielectric materials.

16. The method of claim 15 wherein said dielectric materials include silicon dioxide and silicon nitride.

17. The method of claim 1 wherein said dielectric layer has a thickness of at least 5 nanometers.

18. The method of claim 1 wherein said dielectric layer has a thickness of less than 100 nanometers.

19. The method of claim 1 wherein said dielectric layer has a thickness in the range of from 10 to 50 nanometers.

## FIG. 1

## FIG. 2

## FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EXTENDED ABSTRACTS, no. 2, October 1985, pages 386-387, abstract no. 257, Pennington, New Jersey, US; S.P. TAY et al.: "Thin gate and poly oxides by high-pressure silicon oxidation" * Whole document * | 1-7,10-14,17-19 | H 01 L 21/31 |
| X | EXTENDED ABSTRACTS, no. 2, October 1985, pages 388-389, abstract no. 258, Pennington, New Jersey, US; J.P. ELLUL et al.: "Nitsinitride VLSI dielectrics" * Whole document * | 1,12,15,17-19 | |
| A | FR-A-2 536 208 (RCA CORP.) * Page 4, line 26 - page 5, line 36; claims * | 1-5,8,10-13 | |
| A | EXTENDED ABSTRACTS, vol. 86, no. 2, 19th-24th October 1986, page 565, abstract no. 377, Princeton, N.J., US; N.S. ALVI et al.: "Thin oxide/nitrided-oxide films on polysilicon grown by rapid transient processing" * Whole document * | 15,16 | TECHNICAL FIELDS SEARCHED (Int. Cl.4) H 01 L |
| A | JOURNAL OF VACUUM SCIENCE & TECHNOLOGY A, vol. 3, no. 6, November-December 1985, pages 2077-2081, American Vacuum Society, New York, US; R.W. COLLINS et al.: "The growth of thin oxides on a-Si and a-Si:H in an O2 plasma" * Abstract * | 9 | |

The present search report has been drawn up for all claims

| Place of search | Date of completion of the search | Examiner |
|---|---|---|
| THE HAGUE | 02-06-1988 | GELEBART J.F.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)